(19) Europäisches Patentamt
European Patent Office
Office européen des brevets

(11) EP 1 471 568 A1

(12) **EUROPEAN PATENT APPLICATION**

(43) Date of publication:
**27.10.2004 Bulletin 2004/44**

(21) Application number: **04009212.4**

(22) Date of filing: **19.04.2004**

(51) Int Cl.[7]: **H01L 21/285**, C23C 16/18, C07F 1/00, C07F 3/00, C07F 15/00

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(30) Priority: **22.04.2003 US 420369**

(71) Applicant: **AIR PRODUCTS AND CHEMICALS, INC.**
**Allentown, PA 18195-1501 (US)**

(72) Inventor: **Norman, John Anthony Thomas**
**Encinitas, CA 92024 (US)**

(74) Representative: **Kador & Partner**
**Corneliusstrasse 15**
**80469 München (DE)**

(54) **Precursors for metal containing films**

(57) The present invention is a 1-azaallyl compound of the formula:

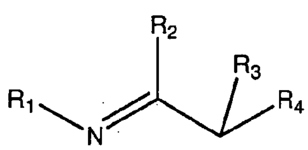

and metal coordination complexes of a representative compound, such as $Et(N)C(tBu)CH_2SiMe_3$, wherein Et = ethyl, tBu = tertiary butyl and Me = methyl, and processes for depositing metal and metal compound films, such as metal nitride and metal oxide films on electronic materials substrates using CVD or ALD of those metal coordination complexes of the compound.

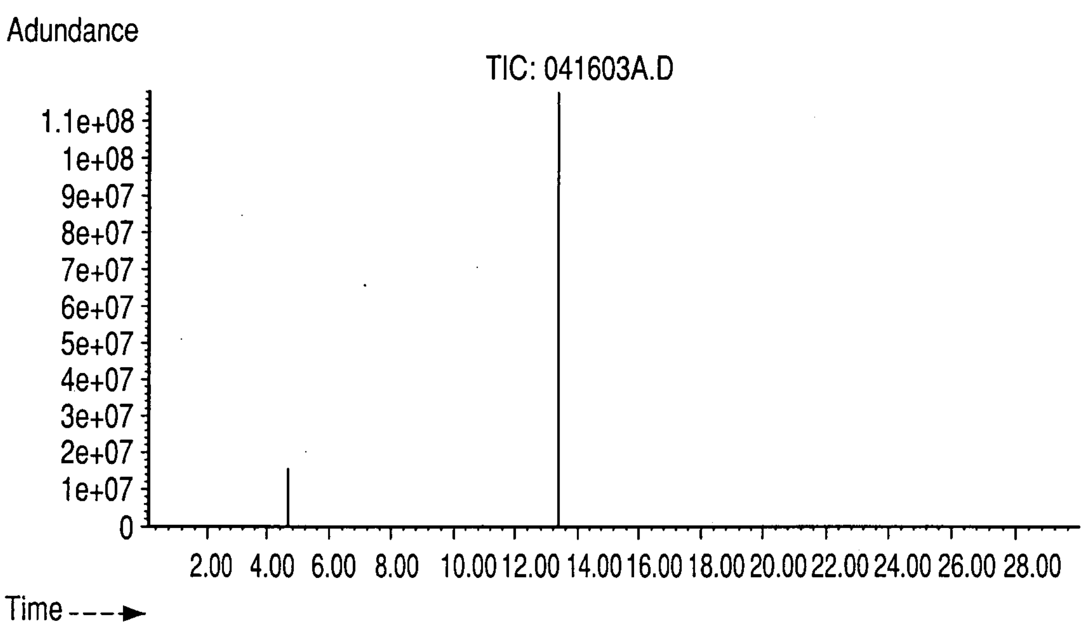


Figure 1

EP 1 471 568 A1

Printed by Jouve, 75001 PARIS (FR)

## Description

BACKGROUND OF THE INVENTION

The semiconductor industry is now using copper interconnects in state of the art microprocessors. These embedded fine metal lines form the three dimensional grid upon which millions of transistors at the heart of the microprocessor can communicate and perform complex calculations. Copper is chosen over the more conventionally used aluminum, since it is a superior electrical conductor, thereby providing higher speed interconnections of greater current carrying capability.

These interconnect pathways are prepared by the damascene process, whereby photolithographically patterned and etched trenches (and vias) in the dielectric insulator are coated with a conformal thin layer of a diffusion barrier material. For copper, this barrier can be tantalum, tantalum nitride, tantalum silicon nitride, titanium nitride, titanium silicon nitride, tungsten nitride, tungsten carbo nitride, ruthenium or other platinum group metals. This thin layer is then coated with a thin 'seed' or 'strike' layer of copper, prior to completely filling in the features with pure copper using physical vapor deposition ("PVD"), chemical vapor deposition ("CVD") or electroplating. In some cases, the seed layer of copper is replaced by a similar conducting thin film.. Excess copper is then removed by the process of chemical mechanical polishing. Since the smallest features to be filled can be less than 0.2 microns wide and over 1 micron deep, it is crucial that both the copper seed, copper glue layer and the diffusion barriers can be deposited using metallization techniques that are capable of evenly filling these deeply etched features, without leaving any voids, which could lead to electrical failures in the finished product.

CVD is a technique that is well known for its ability to 'gap fill' such structures. In the CVD process, a vapor of a volatile organometallic species containing the desired metal is introduced to a substrate surface, whereupon a chemical reaction occurs, in which a thin film containing the metal, as a compound or as a pure element, is deposited on the substrate. Since the metal is delivered in a vapor form as a volatile precursor, it evenly accesses both vertical and horizontal surfaces to yield a very evenly distributed film.

For copper thin films, many CVD precursors are known. The most desirable are those that are highly volatile, give pure copper films and do not introduce contaminating species into the reaction chamber or onto diffusion barrier surfaces. Currently, the biggest challenge facing copper CVD is its poor adhesion to tantalum-based diffusion barriers, leading to delamination of the copper film during chemical mechanical polishing.

CVD copper precursors can be grouped into the following three major categories:

1. CVD copper using Cu(hfac)L type precursors where (hfac) represents 1,1,1,5,5,5-hexafluoro-2,4-pentanedionate anion and (L) represents a neutral stabilizing ligand, usually an olefin an alkyne or a trialkylphosphine.

Many of these compounds are volatile liquids, the most well known being the compound Cu(hfac)tmvs, where tmvs is trimethylvinylsilane, known commercially as CupraSelect®, available from Schumacher unit of Air Products and Chemicals, Inc., Carlsbad, CA, and described in U.S. Patent No. 5,144,049. This class of precursors function by a process of disproportionation, whereby two molecules of Cu(hfac)L react together on a heated substrate surface to give copper metal, two molecules of free ligand (L) and the volatile by-product $Cu(hfac)_2$. This is shown below in Equation (a):

$$\text{(a)} \qquad 2\ Cu(hfac)L \rightarrow Cu + Cu(hfac)_2 + 2L$$

This process is typically run at around 200 ºC. Note that in this process, one half of the copper from the initial precursor cannot be utilized, since it constitutes part of the $Cu(hfac)_2$ by-product. One potential drawback of these precursors is their tendency to chemically degrade upon contact with tantalum or tantalum nitride diffusion barrier surfaces, before the CVD copper film can begin to form. The chemical cause of this adverse reaction is thought to stem from the fluorocarbon character of the 'hfac' portion of the copper precursor, rendering it reactive with tantalum. This degradation leads to a thin layer of chemical debris forming between the tantalum and copper. The lack of direct contact between the tantalum and copper is thought to cause three main effects. First, the mechanical adhesion between the two metals is compromised, resulting in the tendency for copper to delaminate under conditions of chemical mechanical polishing. Secondly, the chemical debris tends to act as an electrical insulator, resulting in poor electrical contact between the copper and the tantalum. Thirdly, since the copper is not growing directly onto the tantalum, it cannot replicate its crystal orientation, and hence, grows as a randomly oriented film (R. Kroger et al, *Journal of the Electrochemical Society,* Vol.146, (9), pages 3248-3254 (1999)).

2. CVD copper from $Cu^{+2}(X)_2$

These compounds typically do not give pure copper films by CVD unless a chemical reducing agent, such as hydrogen, is used in the CVD processing, as shown below in Equation (b):

(b) $Cu(X)_2 + H2 \rightarrow Cu + 2\ XH$

Examples of this type of precursor include; $Cu^{+2}$ bis(β-diketonates) (Wong, V., et al, Materials Research Society , Pittsburgh, PA, 1990, pages 351-57; Awaya, N., *Journal of Electronic Materials,* Vol 21, No 10, pages 959-964, 1992); $Cu^{+2}$ bis(β-diimine) and $Cu^{+2}$ bis(β-ketoimine) compounds (U.S. Patent No. 3,356,527, Fine, S.M., Mater. *Res. Soc. Symp. Proc.,* 1990, pages 204, 415). These copper$^{(+2)}$ compounds are typically solids, and the CVD processing temperatures for them are typically above 200 °C. If these precursors are substantially fluorinated, then similar problems with adhesion, etc., are anticipated, as observed for the Cu(hfac)L compounds mentioned above. $Cu^{+2}$ bis(β-diketonates) have also been demonstrated as ALD copper precursors ( Martensson, P. et al, J. *Electrochem. Soc.,* Vol. 145, No 8, Aug 1998; Jinshan, H. et al, *J. Mater. Res.,* Vol. 17, No. 9, Sept 2002.)

3. CVD copper from (Y)Cu(L) compounds.

In these Cu(+1) precursors, (Y) is an organic anion and (L) is a neutral stabilizing ligand, such as trialkyphosphine. An example of such a precursor is $CpCuPEt_3$, where Cp is cyclopentadienyl and $PEt_3$ is triethylphoshine (Beech et al., *Chem. Mater.* (2), pages 216-219 (1990)). Under CVD conditions, two of these precursor molecules react on the wafer surface in a process, whereby the two stabilizing trialkyphosphine ligands become disassociated from the copper centers, the two (Y) ligands become coupled together and the copper (+1) centers are reduced to copper metal. The overall reaction is shown below in Equation (c).

(c) $2\ (Y)Cu(L) \rightarrow 2\ Cu + (Y\text{-}Y) + 2\ (L)$

However, this type of chemistry poses problems in a manufacturing environment, since the released trialkylphosphine ligands tend to contaminate the CVD chamber and can act as undesired N-type silicon dopants.

A technique for ultra-thin film deposition that is rapidly growing in its applications for semiconductor manufacturing technologies is Atomic Layer Deposition (ALD). In this process, the precursor is chemisorbed onto a substrate to form a 'monolayer' of precursor, i.e., one molecule thick. A second reagent species is then similarly introduced to chemically react with the first chemisorbed layer to grow the desired film onto the substrate surface. For example, aluminum oxide can be grown by the ALD process (Higashi, G.S., et al, *Appl. Phys. Lett.,* 55(19) (1989) page 1963; Georghe S.M., et al, *Int. Symp. On Atomic Layer Epitaxy and Related Surface Processes* (ALE-3) Abstracts, Sendai, Japan, 2527 May (1994) page 38) by first exposing a substrate bearing surface OH groups to trimethylaluminum vapor to form a chemisorbed monolayer that contains Al-O and residual $Al\text{-}CH_3$ bonds and then secondly to water vapor. The water vapor reacts with the residual $Al\text{-}CH_3$ groups to give solid aluminum oxide and methane gas, the latter being exhausted from the ALD chamber as a volatile byproduct. Since the water vapor is added in excess, each aluminum atom in the newly formed aluminum oxide surface becomes functionalized with an OH group. This creates a highly reactive surface for the next pulse of trimethyl aluminum vapor to chemisorb onto, again releasing methane in the process. This cycle is then repeated to grow a perfectly conformal and pure film of aluminum oxide whose thickness is determined by the number of cycles run. Precursors that are best suited to ALD are readily volatile, have high chemical reactivity, permitting their ligands to be readily removed by the addition of specific reagents, and at the molecular level, are dense in the element to be deposited (reacted) onto the substrate surface. A high ratio of the latter element to its supporting ligands translates to a high effective loading of the element per chemisorbed monolayer and hence to a higher ALD growth rate.

ALD copper using copper$^{(+1)}$ chloride (Martensson, P., et al, *Chem Vap Deposition,* 1997, Vol.3, No. 1, page 45) suffers the disadvantage of low volatility of the precursor, ALD copper from copper$^{(+2)}$ bis(tetramethylheptanedionate) (Martensson, P., et al, *J. Electrochem. Soc.,* Vol 145, No 8, August 1998, pages 2926-2931 suffers from the precursor being bulky and mononuclear in copper, and ALD copper using copper$^{(+2)}(hfac)_2$ ( Solanki, R., et al, *Electrochemical and Solid State Letters,* Vol. 3 (10) pages 479-480 (2000)) suffers from the disadvantages of being mononuclear and highly fluorinated.

The prior art problems in depositing metal and metal compound layers on substrates, such as semiconductor or metal barrier layers for electronic materials are overcome by the present invention, which enhances volatility, delivers a full complement of elemental metal from the metal precursor carrier molecule and avoids high melting point precursor compounds. These advantages and additional advantages will be set forth with regard to the present invention in the discussion below.

BRIEF SUMMARY OF THE INVENTION

The present invention is a 1-azaallyl compound of the formula:

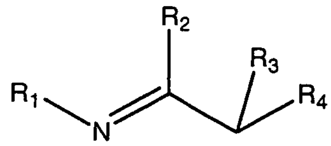

where $R_1$ is selected from the group consisting of H, $C_1$-$C_6$ alkyl, alkenyl, alkynyl, fluoroalkyl, fluoroalkyenyl, and fluoroalkyny; $R_2$ is selected from the group consisting of H, $C_1$-$C_6$ alkyl, alkenyl, alkynyl, fluoroalkyl, fluoroalkyenyl, fluoroalkynyl, alkoxy, fluoroalkoxy; $Si(R_5)_3$ where $R_5$ is $C_1$-$C_6$ alkyl, alkenyl, alkynyl, fluoroalkyl, fluoroalkyenyl, fluoroalkynyl, alkoxy, fluoroalkoxy; $R_3$ and $R_4$ are independently selected from the group consisting of H, $C_1$-$C_6$ alkyl, alkenyl, alkynyl, fluoroalkyl, fluoroalkyenyl, fluoroalkynyl, alkoxy, fluoroalkoxy, $Si(R_5)_3$ where $R_5$ is $C_1$-$C_6$ alkyl, alkenyl, alkynyl, fluoroalkyl, fluoroalkyenyl, and fluoroalkynyl, alkoxy, fluoroalkoxy. In addition, two $R_1$ groups from two identical or two different 1-azaallyl compounds can be connected through an aliphatic hydrocarbon bridge up to $C_6$ in length, optionally, containing teriary amine or ether coordinating groups. Additionally, $R_3$ and $R_4$ groups from one 1-azaallyl compound can independently be connected to the $R_3$ and $R_4$ groups from another identical or different 1-azaallyl compound through an aliphatic hydrocarbon bridge up to $C_6$ in length.

The present invention is also a metal coordination complex of a 1-azaallyl compound of the formula:

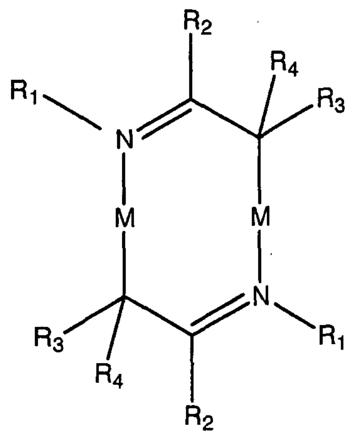

where $R_1$ is selected from the group consisting of H, $C_1$-$C_6$ alkyl, alkenyl, alkynyl, fluoroalkyl, fluoroalkyenyl, and fluoroalkynyl; $R_2$ is selected from the group consisting of H, $C_1$-$C_6$ alkyl, alkenyl, alkynyl, fluoroalkyl, fluoroalkyenyl, fluoroalkynyl, alkoxy, fluoroalkoxy. $Si(R_5)_3$ where $R_5$ is $C_1$-$C_6$ alkyl, alkenyl, alkynyl, fluoroalkyl, fluoroalkyenyl, fluoroalkyny, alkoxy, fluoroalkoxy ; $R_3$ and $R_4$ are independently selected from the group consisting of H, $C_1$-$C_6$ alkyl, alkenyl, alkynyl, fluoroalkyl, fluoroalkyenyl, fluoroalkynyl, alkoxy, fluoroalkoxy, $Si(R_5)_3$ where $R_5$ is $C_1$-$C_6$ alkyl, alkenyl, alkynyl, fluoroalkyl, fluoroalkyenyl, and fluoroalkynyl, alkoxy, fluoroalkoxy; M is selected from the group consisting of: lithium (I), sodium(I), potassium(I), copper (I) and silver (I) and gold (I). In addition, two $R_1$ groups from two identical or two different 1-azaallyl compounds can be can be connected through an aliphatic hydrocarbon bridge up to $C_6$ in length, optionally, containing teriary amine or ether coordinating groups. Additionally, $R_3$ and $R_4$ groups from one 1-azaallyl compound can independently be connected to the $R_3$ and $R_4$ groups from another identical or different 1-azaallyl compound through an aliphatic hydrocarbon bridge up to $C_6$ in length. Further, the present invention is a metal coordination complex of a 1-azaallyl compound of the formula:

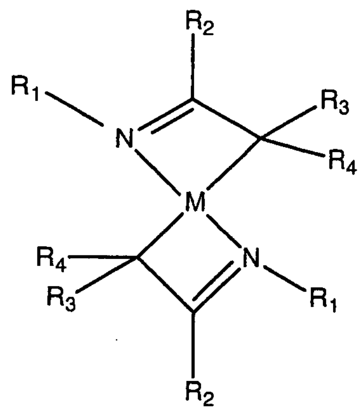

where $R_1$ is selected from the group consisting of H, $C_1$-$C_6$ alkyl, alkenyl, alkynyl, fluoroalkyl, fluoroalkyenyl, and fluoroalkynyl; $R_2$ is selected from the group consisting of H, $C_1$-$C_6$ alkyl, alkenyl, alkynyl, fluoroalkyl, fluoroalkyenyl, fluoroalkynyl, alkoxy, fluoroalkoxy, $Si(R_5)_3$ where $R_5$ is $C_1$-$C_6$ alkyl, alkenyl, alkynyl, fluoroalkyl, fluoroalkyenyl, fluoroalkynyl, alkoxy; fluoroalkoxy $R_3$ and $R_4$ are independently selected from the group consisting of H, $C_1$-$C_6$ alkyl, alkenyl, alkynyl, fluoroalkyl, fluoroalkyenyl, fluoroalkynyl, alkoxy, fluoroalkoxy, $Si(R_5)_3$ where $R_5$ is $C_1$-$C_6$ alkyl, alkenyl, alkynyl, fluoroalkyl, fluoroalkyenyl, and fluoroalkynyl, alkoxy, fluoroalkoxy; M is selected from the group consisting of: iron (II), cobalt (II), and nickel (II) copper (2),Zn(2), Mg (2), Ca(2) , Sr(2), Ba (2). In addition, two $R_1$ groups from two identical or two different 1-azaallyl compounds can be can be connected through an aliphatic hydrocarbon bridge up to $C_6$ in length, optionally, containing teriary amine or ether coordinating groups. Additionally, $R_3$ and $R_4$ groups from one 1-azaallyl compound can independently be connected to the $R_3$ and $R_4$ groups from another identical or different 1-azaallyl compound through an aliphatic hydrocarbon bridge up to $C_6$ in length.

Finally, the present invention is process for depositing a metal or metal containing film on a substrate using the 1-azaallyl metal compound as a volatile precursor in a CVD process, where vapors of the precursor are contacted with a substrate surface in the presence of a reagent gas or gases under conditions of elevated temperature and/or a plasma, such that a chemical reaction occurs on the surface of the substrate to deposit a metal containing film or a process for depositing a metal on a substrate using the 1-azaallyl metal compound as a volatile precursor in an ALD processes, where vapors of the precursor are alternately pulsed with a reagent gas or a reagent gas in a plasma in one or more pulse cycles to deposit one mono-layer of metal or metal containing material per pulse cycle.

## BRIEF DESCRIPTION OF THE DRAWING

Figure 1 is a graph of gas chromatograph/mass spectra related to time for the compound of Example 1.

Figure 2 is a graph of gas chromatograph/mass spectra related to m/z for the compound of Example 1.

## DETAILED DESCRIPTION OF THE INVENTION

The present invention describes novel volatile metal 1-azaaflyl metal compounds and their use as CVD or ALD precursors for the growth of copper seed layers, diffusion barriers, gate electrode metal layers and the like.

These novel compositions are designed to be usefully volatile, yet chemically reactive towards growing metal containing films. Although some 1-azaallyl metal compounds are known in the chemical literature, many of these formulations are not found to be attractive as metal precursors, due to their bulkiness suppressing their volatility and/or undesirable chemical reactivity tending to leave contaminants in the final metal film. For instance, it is well known that phenyl rings, when substituted onto a metal compound tend to render the compound as a relatively high melting solid, and the addition of these bulky groups also lowers the volatility of the final metal complex. Both of these trends, higher melting point and lowered volatility, tend to hamper the effectiveness of the compound as a CVD or ALD precursor, since optimal precursors are either liquid or low melting solids and are of high volatility. For these reasons, aromatic groups are less desireable.

As for chemical reactivity, many of the known 1-azallyl metal compounds contain silicon-nitrogen bonds, which typically are very moisture sensitive. Thus under CVD or ALD conditions, Si-OH species can form as the Si-N bond hydroyses, if water is present, ultimately resulting in silicon contamination of the final metal containing film.

In some of the new compounds described in this disclosure, fluorocarbon substituents are used to increase the volatility of the precursor, and the use of bulky phenyl substituents is avoided.

Additionally, silicon is not substituted onto nitrogen in the ligand framework of these new formulations. Instead, it is substituted on the central and/or on the terminal azaallyl carbon. Substitution of a silicon on the terminal azaallyl carbon is also beneficial, since its presence helps to stabilize the negative charge of the azaallyl ligand, as it is found in the final metal complex.

The novelty of the new compositions of this disclosure is illustrated by considering the known 1-azaallyl ligands described in the open literature (C. F. Caro et al, Coordination Chemistry Reviews 219-221 (2001) 605-663) and shown below in Formulae 1-10. Note, these ligands are shown in their neutral form, as distinct from their deprotonated anionic state, which is the form in which they are complexed to various metal ions to constitute the final 1-azaallyl metal compounds. An examination of the structures of these azaallyl ligands reveals the following features:

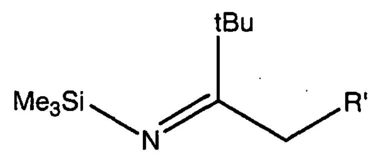

R '= H;
R' = $SiMe_3$
R' = $C_6H_4Me$-4
R' = $C_6H_3Me_2$-2,5
R' = $C_{10}H_7$-1
R' = Ph
R'=C(H)Rn-Bu

FORMULA 1

The 1-azaallyl ligands shown in Formula 1 are all functionalized with $Me_3Si$ bonded to nitrogen, thus making the complex susceptible to hydrolysis and silicon incorporation into the final metal film. A number of the formulations also bear aromatic groups, thus hindering volatility and raising melting points. There are no substituents bearing fluorine.

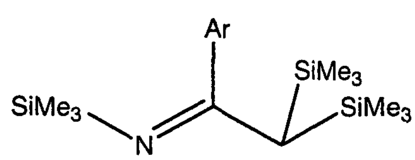

Ar = Ph
Ar = $C_6H_4F$-4
Ar = $C_6H_4Br$-4
Ar = $C_6H_4OMe$-4
Ar = $C_6H_4$n-Bu-4
Ar = $C_6H_3Me$-2,6

FORMULA 2

The 1-azaallyl ligands shown in Formula 2, similar to the ligands shown in Formula 1, are also substituted with $Me_3Si$ on nitrogen, and all bear volatility hindering aromatic groups substituted at the central 1-azaallyl carbon, which also serve to raise the melting point of these compounds. There are no substituents bearing fluorine.

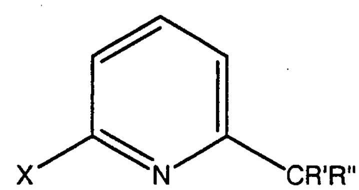

X = R' = R" = H
X = H, R '= R" = $SiMe_3$
X = H, R' = t-Bu, R" = =$CH_2$
X = R' = H, R" = R
X = H, R' = Ph, R" = R
X = H, R' = R" = Ph
X = R' = H, R" = Me
X = R' = H =, R" = $SiMe_2Bu$
X = Me, R' = R" = R
X = Me, R' = H, R" = R
X = Me, R' = R" = H
X = C(H)$SiMe_3$, R' = H, R" = R
X = R' = H, R" = Ph
X = C(H)$SiMe_3$, R' = R" = R

FORMULA 3

In each case in Formula 3, the nitrogen atom of the 1-azaallyl backbone is a part of a pyridine ring, thus adding to the bulk, lowering the volatility and raising the melting point of these compounds. There are no substituents bearing fluorine.

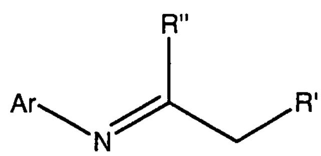

Ar = $C_6H_3Me_2$-2,5, R'= R"=$SiMe_3$
Ar = H, R" = Pr
Ar = R, R" = R' = Ph
Ar = $SiMe_2$(OMe), R" = Ad
Ar = $SiMe_3$, R" = Ad

FORMULA 4

In Formula 4, there are three examples of $SiMe_3$ substituted on the 1-azaally nitrogen, one of which also bears an aromatic ring. In one example, $SiMe_3$ is substituted on both of the 1-azaallyl carbons, but is also functionalized with an aromatic ring on the 1-azaallyl nitrogen. In another example and when $SiMe_3$ in not substituted on the 1=azaallyl nitrogen, the compounds bear aromatic rings. There are no substituents bearing fluorine.

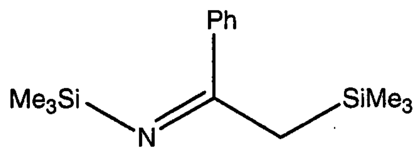

FORMULA 5

In Formula 5, the 1-azaallyl nitrogen is substituted with $SiMe_3$, and the central carbon of the ligand bears an aromatic ring. There are no substituents bearing fluorine.

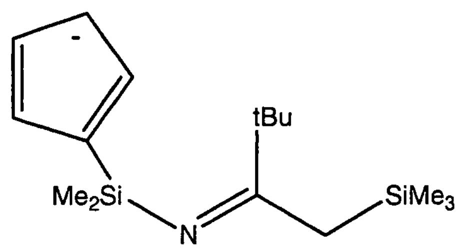

FORMULA 6

In Formula 6, the 1 -azaallyl nitrogen is functionalized with a dimethylsilycyclpentadienide group, which adds both bulk and a hydrolytically labile silicon nitrogen bond. There are no substituents bearing fluorine.

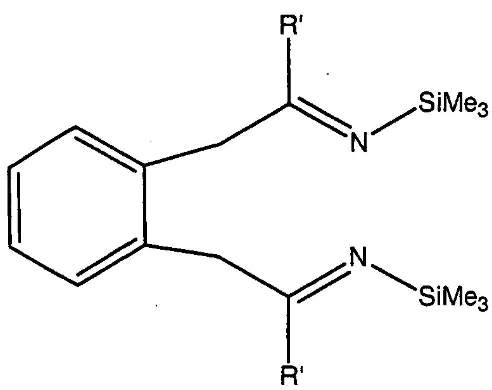

R' = Ph
R' = t-Bu

FORMULA 7

Formula 7 shows $SiMe_3$ groups substituted onto the 1-azaallyl nitrogens, in addition to the two 1-azaallyl ligand groups being bonded to a bulky phenyl ring. One formulation bears additional phenyl rings substituted on the

central 1-azaallyl carbons. There are no substituents bearing fluorine.

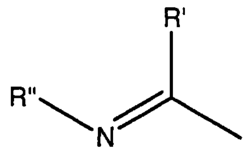

R" = $CHMe_2$, R' = Me
R" = H, R' = Ph
R" = H, R' = $C_6H_4Me$-4
R" = Me, R' = Ph
R" = i-Pr, R' = Me
R" = Ph, R' = Me
R" = Ph, R' = t-Bu

FORMULA 8

Formula 8 shows five structures bearing phenyl rings, and none of the structures show $SiMe_3$ substituted on the terminal carbon of the 1-azaally ligand, where it can stabilize the negative charge of the 1-azaallyl anion. There are no substituents bearing fluorine.

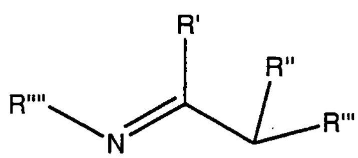

R'''' = t-Bu, R' = R" = R'''= Me
R'''' = C($PhCMe_2$), R' = R" = COOMe
R'''' = C($PhCMe_2$), R' = R"= Ph
R'''' = R' = R" = R''' = Ph
R'''' = R" = H, R' = t-Bu, R''' = Pr

FORMULA 9

In Formula 9, there are five structures bearing aromatic phenyl groups, and none of the structures bear trialkylsilyl groups bonded to the 1-azaallyl terminal carbon atoms. There are no substituents bearing fluorine.

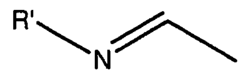

R' = t-Bu
R' = Et
R' = iPr
R' = H
R' = $CHMe_2$

FORMULA 10

In Formula 10, none of the five structures have trialkylsilyl substituents on the 1-azaallyl terminal carbon, and none of the substituents are fluorinated.

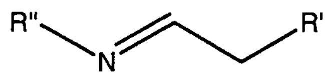

R" = i-Pr, R' = $CH_2$ Ph
R" = c-hex, R' = $CH_2Me$
R" = i-Pr, R' = $CH_2Me$
R' '= t-Bu, R' = $CH_2Me$
R" = t-Bu, R' = =C(H)Me
R" = Ph, R' = $C(Me)_2CH_2$
R" = Et, R' = Me
R"= t-Bu, R' = Me
R" = t-Bu, R' = Et
R" = Ph, R' = $C(Me)_2CH_2$
R" = t-Bu, R' = CH=CHPh
R" = t-Bu, R' = i-Pr
R" = t-Bu, R' = $CH_2Ph$

FORMULA 11

Formula 11 shows that. none of the thirteen structures bears a trialkylsilyl substituent on the 1-azaally terminal carbon, three of the structures contain aromatic pheny rings, and none of the structures bear fluorocarbon substituents.

As can be seen from the above analysis, the structural features of known ligands of 1-azaallyl metal compounds can be summarized as follows:

- none of them bear fluorocarbon substituents to aid in their vaporization;
- if trialkylsilyl substituents are present (typically as trimethylsilyl), it is frequently bonded to the 1-azaallyl terminal nitrogen, thereby rendering the silicon nitrogen bond of the final metal compound water sensitive, thus permitting the potential for silicon to become incorporated into the metal containing film grown by CVD or ALD, and;
- if the trialkylsilyl group present is bonded to the more desirable 1-azaally terminal carbon, then other undesirable and undesireably located substituents, such as phenyl and trialkylsilyl on nitrogen are also present. The presence of aromatic phenyl rings tends to suppress volatility and increase the melting point of the metal compounds derived

from these ligands.

In the compounds shown in Formula 3, the central carbon and terminal nitrogen of the 1-azaallyl ligand is a part of an aromatic pyridine ring, which presents the problems of higher melting points and lowered volatility.

Thus it can be concluded that none of the known 1-azaallyl ligands have the following desirable features:

- trialkylsilyl substitution on the 1-azaallyl terminal carbon, with no aromatic phenyl ring susbstituted elsewhere on the ligand and no trialkylsilyl groups substituted onto the 1-azaallyl terminal nitrogen, and;
- fluorocarbon substituents present with or without trialkylsilyl groups substituted onto the 1-azaallyl terminal carbon and no aromatic phenyl groups elsewhere on the ligand.

Therefore, the new 1-azaallyl ligands of the present invention can be summarized in Formula 12, below:

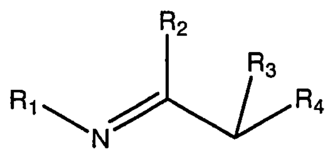

FORMULA 12

where $R_1$ can be H, $C_1$-$C_6$ alkyl, alkenyl, alkynyl, fluoroalkyl, fluoroalkyenyl, fluoroalkynyl; $R_2$ is H, $C_1$-$C_6$ alkyl, alkenyl, alkynyl, fluoroalkyl, fluoroalkyenyl, fluoroalkynyl, alkoxy, fluoroalkoxy, $Si(R_5)_3$ where $R_5$ is $C_1$-C $_6$ alkyl, alkenyl, alkynyl, alkenyl, alkynyl, fluoroalkyl, fluoroalkyenyl, fluoroalkyny, alkoxy, fluoroalkoxy; $R_3$ and $R_4$ can independently be H, $C_1$-$C_6$ alkyl, alkenyl, alkynyl, fluoroalkyl, fluoroalkyenyl, fluoroalkynyl, alkoxy, fluoroalkoxy, $Si(R_5)_3$ where $R_5$ is $C_1$-$C_6$ alkyl, alkenyl, alkynyl, alkenyl, alkynyl, fluoroalkyl, fluoroalkyenyl, fluoroalkynyl, alkoxy, fluoroalkoxy. In addition, two $R_1$ groups from two identical or two different 1-azaallyl compounds can be can be connected through an aliphatic hydrocarbon bridge up to $C_6$ in length, optionally, containing teriary amine or ether coordinating groups. Additionally, $R_3$ and $R_4$ groups from one 1-azaallyl compound can independently be connected to the $R_3$ and $R_4$ groups from another identical or different 1-azaallyl compound through an aliphatic hydrocarbon bridge up to $C_6$ in length.

The choice of a specific 1-azaallyl ligand would depend upon which metal it would be coordinated with to form a metal complex and the type of process for which the resulting metal complex was designed to to utilized (i.e., CVD, ALD) to grow metal containing film, the choice of metal in turn determined by what ALD, CVD or other metallization process the complex was targeted for use. For instance, it is well know that some fluorinated CVD copper complexes tend to deleteriously react with certain diffusion barriers, such as tantalum, to yield fluorinated breakdown products, which prevent the copper film from adhering to the tantalum barrier. In such an application, selection of a novel 1-azaallyl, where $R_1$, $R_2$ and $R_3$ do not contain fluorine, would be advised. However, in applications where tantalum or similar metal is not encountered, the use of novel 1-azaallyl compounds, where $R_1$, $R_2$ and $R_3$ have fluorocarbon character, could be beneficial due to the enhanced volatility of the precursors.

These new 1-azaallyl ligands can the be deprotonated to form 1-azaallyl anions and then coordinated to different metals to form new metal complexes. When the metal is monovalent, such as Lithium$^{(+1)}$, Sodium$^{(+1)}$, Potassium$^{(+1)}$, Cu$^{(+1)}$, Ag$^{(+1)}$ etc., the 1-azallyl compounds will have the structure as shown below in Formula 13, wherein $R_1$, $R_2$, $R_3$ and $R_4$ are as above:

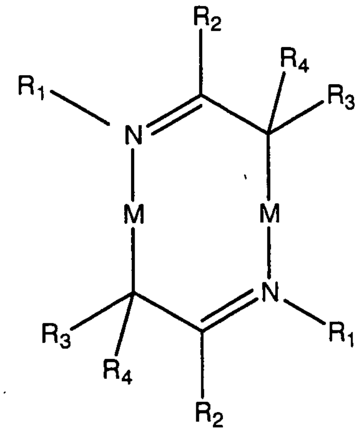

FORMULA 13

Further, when the metal is divalent, i.e., $Fe^{+2}$, $Co^{+2}$, $Ni^{+2}$ $Cu^{+2}$, $Zn^{+2}$, $Mg+^{2}$, $Ca+^{2}$, $Sr^{+2}$, or $Ba^{+2}$ and coordinated to two deprotonated 1-azaallyl ligands, the result is the structure shown below in Formula 14, wherein $R_1$, $R_2$, $R_3$ and $R_4$ are as above:

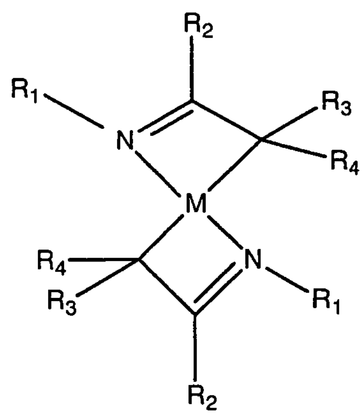

FORMULA 14

Further, the present invention teaches the use of the above shown 1-azaallyl metal compounds as volatile precursors in CVD processes, where vapors of the precursors are contacted with a substrate surface, typically in the presence of a reagent gas or gases under conditions of elevated temperature and/or a plasma, such that a chemical reaction occurs on the surface of the substrate to deposit a metal containing film. Thus a chemical reducing agent, such as hydrogen, silane, borane, etc., can be used to create a metallic film, or ammonia or an oxidant can be used to grow a metal nitride or oxide, respectively. If two or more metal precursors are used simultaneously, a metal alloy or a mixed metal compound, such as a mixed metal nitride or oxide, an be produced.

Alternatively, these precursors can be used in ALD processes, where vapors of a metal compound are alternately pulsed with a reagent gas, including the use of plasma conditions, to deposit one mono-layer of metal containing material per pulse cycle. For instance, the metal precursor vapors can be alternatively pulsed with a reducing agent, such as atomic hydrogen, silane, borane, etc., to grow a metallic film. If more that one metal precuror is alternated in this process, then a metal alloy can be produced. Using reagent gases alternating with precursor pulses can be used to grow mixed metal compounds. For instance, if ammonia or other suitable reagent gas is alternated with a metal or alternately with more than one metal, then a metal nitride or mixed metal nitride will be formed.

The binuclear and mononuclear metal complexes described in the present invention are highly suitable for ALD since they are highly volatile, are very reactive at low processing temperatures towards loss of their ligands to

form a metal-containing film. In addition, the binuclear compounds bear two metal atoms per molecule of precursor in the chemisorbed layer thus providing a high loading of metal per reaction cycle.

The complexes described in the present invention are highly suitable for the ALD growth of copper, copper alloys, and other metal containing films, such as metal sulfide, metal oxide, metal nitride, etc. These films are created by reacting the monolayers of precursor in the ALD technique by thermal processing, plasma processing or chemical reduction, by treatment with other metal compounds or by processing with sulfur,oxygen or nitrogen containing reagents respectively. The present invention also teaches a superior process for growing copper or other metal films by ALD, whereby the chemisorbed monolayer of precursor is reacted with water vapor or water vapor plus an oxidant in ALD type cycles to form an ultra thin film of copper or other metal oxide. This copper or other metal oxide is then reduced by hydrogen gas, remote hydrogen plasma or other suitable reductant, to form a metallic film. These oxidation and reduction steps can be carried out in rapid succession or reduction can be carried out after a number of layers of oxide have been grown. This improved ALD approach achieves a greater degree of control over the formation of precursor monolayers since the precursor can strongly chemisorb onto an oxide or hydroxide-type of surface, rather than weakly absorbing onto a metallic surface. The precursors described in the present invention are especially suited to this approach, since they are hydrolytically labile, while not permitting the formation of contaminating SiOH species which can become trapped in the final films, explained as followsln the case of the binuclear 1-azaallyl complex, [-CuN(Et)=C(tBu)C($SiMe_3$)(H)-CuN(Et)=C(tBu)C($SiMe_3$)(H)-], water vapor can break the organometallic Cu-C bond in the precursor by protonation of the carbon atom, while at the same time forming copper oxide. In addition, water can also help to break up the 1-azaallyl ligand by hydrolysis to ethylamine and 1-trimethylsilyl-3,3-dimethylbutan-2-one, thereby yielding smaller molecular fragments that are more readily evacuated from the ALD chamber as volatile by products, as shown below in equation (d).

(d) [-CuN(Et)=C(tBu)C($SiMe_3$)(H)-CuN(Et)=C(tBu)C($SiMe_3$)(H)-] + 3 $H_2O$ =

2 $EtNH_2$+ 2 $Me_3SiCH_2C(O)tBu$ + $Cu_2O$

The copper oxide, thus produced, is then reduced to copper metal by treatment with hydrogen gas, hydrogen plasma or other suitable reducing agent. Likewise, a bis(1-azaallyl) compound of a divalent metal could silmilarly be used to grow a metal oxide as shown below in eqation (e), where the metal in question is cobalt. The cobalt oxide, thus produced, could then subsequently be reduced to cobalt metal.

(e) $[Me_3SiCHC(tBu)=N(Et)^-]_2\ Co^{+2}$ + 3 $H_2O$ = CoO + 2 $EtNH_2$ + 2 $Me_3SiCH_2C(O)tBu$

In summary, the process sequence for growing an ALD metal film is illustrated for copper using this superior process, as follows: a fresh metal, metal containing, metalloid such as silicon or germanium, or metalloid-containing surface is reacted with water, hydrogen peroxide, alcohol, oxygen or other suitable reagent to give a new surface bearing hydroxyl (OH), OH and oxide, or oxide oxygen groups. A monolayer of copper complex is then chemisorbed onto this surface to give copper oxide or hydroxide type species. A pulse of [-OH] bearing reagent may then be added to achieve a higher degree of surface hydroxylation. A pulse of copper complex is then added to chemisorb a monolayer of it onto the hydroxide/oxide surface. The cycle of oxidant/copper precursor is continued until the desired thickness of oxide is achieved, at which point the process is terminated by chemical reduction of the oxide layers to copper metal using a suitable volatile reducing agent, such as hydrogen, hydrogen plasma, silanes, and boranes. The thickness of the oxide layers is carefully chosen, such that the oxide can be rapidly and completely reduced to metal. Once this is complete, then the entire cycle can be restarted to yield an overall thicker final copper film. If a 1-azaallyl-type precursor, such as [-CuN(Et)=C(tBu)C($SiMe_3$)(H)-CuN(Et)=C(tBu)C($SiMe_3$)(H)-] is utilized, it is thought that chemisorption onto a [-Cu-OH] type surface site to form [Cu-O-Cu] should be strongly driven, due to the basicity of the ligands driving proton removal from the OH group. This chemisorption is far stronger than the chemisorption of the same copper precursor directly onto a growing copper surface to give [-Cu-CuL-] type species, which is representative of a typical ALD copper process. Thus, greater control over monolayer saturation is achieved, which is the key to a successful ALD approach. The resulting [-Cu-O-CuL], [-Cu-O-Cu] or [-Cu-O-Cu-OH-] surface is then reduced to [-Cu-Cu] to give a smooth copper film. Similar advantageous benefits also hold true for the growth of a divalent metal oxide that can then be reduced to a metallic film, as shown earlier for cobalt.

This technique can also be applied to the formation of mixed metal alloy thin films by ALD. In this technique, layers of a first metal oxide grown by ALD are alternated with additional layers of a second metal oxide, which can also be reduced to elemental metal by hydrogen or another reducing agent simultaneously with the reduction of the first metal oxide to yield an alloy of the two metals. The ratio of the first metal oxide oxide layers to subsequent alloying

metal oxide layers determines the composition of the final metal alloy after reduction. For instance, copper oxide could be grown alternately with palladium oxide, and this composite reduced to give a copper palladium alloy. Similarly, more than one additional metal oxide species can be incorporated into the first metal oxide to yield, after reduction, an alloy comprised of the first metal and at least two other metals. For copper, specific copper alloys are more electromigration resistant than pure copper, and hence, are very important for the fabrication of copper interconnects. If the ALD copper alloy film forms a seed layer for subsequent electroplated copper, the alloying element(s) can be diffused into the bulk of the electroplated copper by applying a thermal anneal step, resulting in a copper film containing uniformly distributed alloying elements.

Some copper alloys are advantageous for other reasons, such as the alloying element segregating to the surface of the copper film after a thermal anneal, whereupon it can be reacted with a processing gas or vapor to provide a protective layer. An example would be the growth and annealing of a copper/magnesium alloy, whereby the magnesium segregates to the copper surface, where it is subsequently oxidized to form a protective layer of magnesium oxide (Murarka, S., *Critical Reviews in Solid State and Materials Sciences,* 20 (2), pages 87-124 (1995)).

Other monovalent metals ($M^{+1}$) can also be used instead of copper to give [-($M^{+1}$)N(Et)=C(tBu)C($SiMe_3$)(H) -($M^{+1}$)N(Et)=C(tBu)C($SiMe_3$)(H)-] type of 1-azaallyl complexes, and other divalent metals $M^{+2}$can be used instead of cobalt to give [$Me_3$SiCHC(tBu)=N(Et)]$_2$ ($M^{+2}$) described in the present invention, thereby yielding volatile metal complexes, other than copper and cobalt, that are usefull for CVD or ALD films containing those respective metals. Examples of divalent metals from which useful compounds of novel 1-azaallyl ligands can be synthesized include; magnesium, strontium, barium, iron, nickel, palladium, platinium, and zinc. Similarly, trivalent metals $M^{+3}$ can be used to form 1-azaallyl compounds of the type [$Me_3$SiCHC(tBu)=N(Et)]$_3$ $M^{+3}$. Examples of such trivalent metals, include, but are not limited to; yttrium, lanthanum, titanium, zirconium, hafnium, niobium, tanatlum, chromium, tungsten, ruthenium, osmium, rhodium and iridium silver, gold, cobalt, ruthenium, rhodium, platinum, palladium, nickel, osmium, iridium, iron, sodium, potassium and lithium. Such complexes can also be used in conjunction with, or in alternating sequences with [-CuN(Et)=C(tBu)C($SiMe_3$)(H)-CuN(Et)=C(tBu)C($SiMe_3$)(H)-] type copper complexes to give copper alloys, after a thermal anneal, or with each other in different combinations to yield different alloys.

In another ALD technique, the new 1-azaallyl compounds of this disclosure can be utilized in an ALD scheme, whereby a metal film or metal alloy film is prepared by applying alternating pulses of precursor and halogen containing reagent gas to yield an ALD film of metal halide, which can subsequently be reduced to pure metal using atomic hydrogen, silanes, boranes etc. An example of this approach is given below in equation (e) for the reaction between the 1-azaally compound [-CuN(Et)=C(tBu)C($SiMe_3$)(H)-CuN(Et)=C(tBu)C($SiMe_3$)(H)-] and HCl to give copper chloride and free 1-azaally ligand. Equation (f) shows the reduction of copper chloride to copper metal using diethylsilane. The copper halide can then be reduced to copper metal by using a variety of different reducing agents, including, but not limitited to, atomic hydrogen, silanes, boranes, alanes etc.

(e) [-CuN(Et)=C(tBu)C($SiMe_3$)(H)-CuN(Et)=C(tBu)C($SiMe_3$)(H)-] + 2 HCl = 2 N(Et)=C(tBu)$H_2$C$SiMe_3$ + 2 CuCl

(f) $CuCl + Et_2SiH_2 = Et_2SiCl_2 + Cu^0$

These new approaches to ALD copper and copper alloys and other copper containing films can also be applied using known copper precursors, such as those described in the 10 groups below used alone or in conjunction with the new 1-azaallyl compounds of this disclosure:

1 ) $Cu^{+1}$ (β-diketonate)(L)n type precursors, where (n) is 1 or 2 or where (L) represents an olefin, a diene, a tetraene, an alkyne trialkylsilylalkenes, trialkylsilyldienes trialkylsilytetraenes, trialkylsilylacetylenes, trialkoxysilylalkenes, trialkoxysilyldienes trialkoxysilylacetlylenes, trialkoxysilyldienes, trialkyl phosphines, and trialkoxyphoshines, nitriles, isonitriles, isocyanates, carbon monoxide, and and (β-diketonate) is represented by (hfac), acetylacetonate (i.e., acac), 3-halosubstituted acac; 1,5-dihalo substituted acac, 1,1,1-trihalosubstituted acac, alkylacetoacetates (methylacetoacetate), alkyl-oxo-butanoates, aryl acetoacetates. β-diketonate can also be substituted by aryl or alkyl substituted, halogenated, partly halogenated or non-halogenated β-diimine or β-ketoimine, malonaldehyde, 2-halomalonaldehyde, malonaldehyde diimines, dialkyl malonates (e.g. dimethyl malonate), diaryl malonates, arylalkyl malonates, 1,3-bis(trialkylsilyl)-1,3-propanedionate and 1-trialkylsilyl-3-alkyl-1,3-propanedionate.

2) $Cu^{+1}$ (alkoxide)n type precursors where (n) is typically from 4-6 and (alkoxide) represents t-butoxy, methoxy, ethoxy, isopropoxy, unsaturated alkoxides (e.g. 2-methyl-3-butene-2-oxy, 2-methyl-3-butene-2-oxy), alkynyloxy

(e.g. propargyl alkoxide), allyloxy, vinyloxy, allylphenoxy, alkylphenoxy or mixtures thereof. Additional alkoxides include amino, imino, cyano and halogen substituted alkoxides, trialkylsilanoate, trialkoxysilanoate, dialkylalkylaminosilanoate, dialkylalkyliminosilanoate.

3) $[Cu^{(+1)}(amide)]n$ type precursors, where (n) is typically 4-6 and (amide) represents secondary amide anion. Substituents on the amide nitrogen, include, but are not limited to, the following representative groups: alkyl, aryl, allyl, arylalkyl, silylalkyl, silylaryl, alkylether, halogenated and partially halogenated dialkylsilyl.

4) $[Cu^{(+1)}(R)]n$ type precursors, where (n) is typically between 4-6 and (R) represents alkyl, halogenated or partially halogenated alkyl, trialkoxysilylalkyl, trialkylsilylalkyl, trialkoxysilylalkyl, allyl, vinyl, alkynyl, aryl, mono and multialkyl substituted aryls, halo substituted aryls, arylalkyls, halo substituted araalkyls, alkoxy substituted aryls, alkoxy substituted aralkyls, iminosubstituted aryls and iminosubstituted alkyls.

5) $Cu^{(+2)}$ bis(alkoxide) type precursors, including, but not limited to, alkoxides substituted with amine, imine, ether, vinyl, alkynyl, aryl, trialyklsilyl or halogen. The alkoxide can also be dialkylalkylaminosilanoate or dialkylalkyliminosilanoate.

6) $Cu^{(+2)}$ bis [β-diketonate] type precursors, where [β-diketonate] can be substituted with alkyl, halogenated alkyl, vinyl, alkynyl, aryl, trialkylsilyl, halogen or ether groups.

7) $Cu^{(+2)}$ bis(β-ketoimides), where the β-ketoimine is substituted with alkyl, halogenated alkyl, trialkylsilyl, trialkoxysilyl, trialkylsiloxyl, aryl, halogenated aryl, ether or amine groups.

8) $Cu^{(+2)}$ (β-diimides), where the β-diimine is substituted with hydrogen, alkyl, halogenated alkyl, trialkylsilyl, trialkoxysilyl. trialkylsiloxy, aryl, halogenated aryl, amine and ether groups.

9) $Cu^{(+1)}$(amidinates), where (amidinate) represents alkyl-amidinate, aryl-amidinate, halo-amidinate, trialkylsilyamidinate, trialkylsilylalkylamidinate and trialkoxysilylamidinate structures.

10) $Cu^{(+1)}(R)nL$ type precursors, where (n) is typically 1-3 and where (R) represents alkyl, halogenated alkyl, amine substituted alkyl, imine substituted alkyl allyl, vinyl, alkynyl, aryl, alkyl substituted aryls, halosubstituted aryls, arylalkyls, halo substituted arylalkyls, alkoxy substituted aryls, alkoxy substituted arylalkyls, nitriles, haloalkanes, cyclopentadienyl, halogen substituted cyclopentadienyl, alkyl substituted cyclopentadienyl, halogenatedalkyl substituted cyclopentadienyl. L is a neutral stabilizing ligand of the type trialkylphosphine, triarylphosphine, dialkylphosphine, CO, nitrile, isonitrile, isocyanides, olefin, alkyne.

The ligand basicity of the new 1-azaallyl type complexes described in this disclosure can also be used in another ALD approach, where a monolayer of chemisorbed complex of the type $[-CuN(Et)=C(tBu)C(SiMe_3)(H)-CuN(Et)=C(tBu)C(SiMe_3)(H)-]$ is treated with a volatile acid ligand, such as a β-diketone, which protonates off the ligand of the complex and in doing so forms a metastable copper (+1) (β-diketonate) species, which then disproportionates to give volatile copper (+2) $(β\text{-diketonate})_2$ and copper metal. This same chemistry can also be used in a CVD process for growing a copper film.

In addition, it is anticipated that the CVD and ALD processes for growing pure copper metal, copper metal-containing metallic alloys, and other copper-containing films or other metal films and their alloys using any of the above complexes will operate effectively under the following process conditions, in any combination:

(a) within a temperature range of zero to 500 degrees Celcius;
(b) within a pressure range of 1 mTorr to greater than 760 Torr;
(c) with the use of microwave generated plasma, either remote or direct, UV radiation or elecron beam;
(d) with the use of the following reagent gases added stoichiometrically or catalytically: hydrogen, ammonia, water vapor, oxygen, nitrous oxide, hydrazines, amines, alcohols, phosphines, silanes, boranes, alanes, or other chemically reactive species capable of yielding metal containing films from these metal precursors;
(e) vapors of other metal precursors in conjunction with reagent gases as in (d) to grow copper metal alloys or other mixed metal compounds, including copper, exemplified by superconducting YBaCu oxides; and/or,
(f) volatile sulfur containing volatile compounds can be added during the CVD process to form metal sulfides.

Any of the above compounds may also form useful precursors for copper CVD, when complexed to various neutral ligands, such as; alcohols ethers, amines, alkenes, alkynes, arenes, phosphines, carbon monoxide, nitriles,

isonitriles, cyanates, or isocyanates, imines, diimines, nitrogen-containing heterocycles.

Especially beneficial compositions may be those complexes that are liquid or especially volatile.

In the above complexes, where the ligand system is not bearing oxygen, for instance, the [-($M^{+1}$)N(Et)=C(tBu)C($SiMe_3$)(H)-($M^{+1}$)N(Et)=C(tBu)C($SiMe_3$)(H)-] system, it is anticipated that volatile complexes of oxophillic metals, such as; magnesium, zirconium, etc., could be prepared, that would be chemically compatible with copper complexes prepared from the same or similar ligands. CVD using a mixture of two such compounds should permit the deposition of copper alloys, such as; Cu/Mg or Cu/Zr, which are known to possess properties of enhanced reliability and improved electromigration resistance. With the selection of appropriate ligands, such mixtures can be prepared that are liquid blends, and thus, especially suited to direct liquid injection delivery to a CVD chamber.

Further, selected substituents on selected atoms, that form the core 1-azaallyl ligands in all of the above compounds, may also include groups containing tin, such that this element can become intermingled with the copper CVD film to give an alloy that is more electromigration resistant, than pure copper.

Example 1

Synthesis of a Novel 1-azaallyl Ligand

The ligand shown in Formula 12 where $R_1$ is ethyl, $R_2$ is tButyl, $R_3$ is H and $R_4$ is $SiMe_3$ is prepared using the following protocol. First, 0.1 mole of trimethylacetonitrile is added to 250 ml of dry tetrahydrofuran under nitrogen and cooled to -78°C. 100 ml of 1M trimethylsilylmethyllithium in pentane is then slowly added over 3 hours maintaining -78°C. The reaction mixture is then allowed to warm to room temperature, and 0.1 mole of ethyl bromide is added over 15 minutes. The reaction mixture is then stirred overnight. At this point, if the ligand is required to be isolated, the solvent is distilled off at atmospheric pressure and the remaining liquid vacumm distilled over into a liquid nitrogen cooled receiver. After thawing out, this liquid is then distilled to give the pure ligand Et(N)C(tBu)$CH_2SiMe_3$. Figure 1 shows the Gas Chromatography/Mass spectra for the above ligand after distilling off most of the tetrahydrofuran, the latter showing at 4.3 mins. and the 1-azaallyl ligand at 13.385 mins. The parent M = 199 minus one methyl group (M=15) is apparent at M = 199-15 = 184 for the 1-azallyl ligand.

Example 2

Synthesis Of A Novel 1-Azaallyl Metal Compound Using A Monovalent Metal

First, 0.1 mole of pure 1-azaallyl ligand from the synthesis of Example 1, above, is added to 300 ml of dry tetrahydrofuran under nitrogen and cooled to -78°C. Then 0.1 mole of lithium diisopropylamide in 100 ml of dry tetrahydrofuran under nitrogen is slowly added over 30 minutes, and the reaction mixture is allowed to warm to room temperature. A second flask is then loaded with 0.1 moles of cuprous chloride in 100 ml of dry tetrahydrofuran under nitrogen and cooled to -20°C while stirring. The first solution is then added dropwise to the stirring cuprous chloride mixture over the course of one hour. The reaction mixture is then held at -20°C for one additional hour, then allowed to warm back up to room temperature and left stirring overnight. The next day, the solvent is stripped off under vacuum, and the solid reaction mixture is extracted with 100 ml hexane three times under nitrogen. The hexane is then stripped off under vacuum, and the resulting solid is sublimed under dynamic vacuum.

However, the final metal complex could also be prepared directly from the crude reaction mixture prior to distilling off solvent, as follows. The reaction mixture is cooled back down to -78°C, and 0.1 mole of lithium diisopropylamide in 100 ml of dry tetrahydrofuran is slowly added over 30 minutes, then the reaction mixture is allowed to warm to room temperature. A second flask is then loaded with 0.1 moles of cuprous chloride in 100 ml of dry tetrahydrofuran under nitrogen and cooled to -20°C, while stirring. The first solution is then added dropwise to the stirring cuprous chloride mixture over the course of one hour. The reaction mixture is then held at -20°C for one additional hour, then is allowed to warm back up to room temperature and left to stir overnight. The next day the solvent is stripped off under vacuum, and the solid reaction mixture is extracted with 100 ml hexane three times under nitrogen. The hexane is then stripped off under vacuum, and the resulting solid sublimed under dynamic vacuum to yield the pure copper(+1) compound.

Example 3

Synthesis Of A Novel 1-Azallyl Metal Compound Using A Monovalent Metal

First, 0.1 moles of pure 1-azaallyl ligand from the synthesis above is added to 300 ml of dry tetrahydrofuran under nitrogen and cooled to -78°C. Then 0.1 mole of lithium diisopropylamide in 100 ml of dry tetrahydrofuran under

nitrogen is slowly added over 30 minutes, then the reaction mixture is allowed to warm to room temperature. A second flask is then loaded with 0.05 moles of cobalt bromide in 100 ml of dry tetrahydrofuran under nitrogen and is cooled to -20°C while stirring. The first solution is then added dropwise to the stirring cobalt bromide mixture over the course of one hour. The reaction mixture is then held at -20°C for one additional hour, then allowed to warm back up to room temperature and left to stir overnight. The next day, the solvent is stripped off under vacuum, and the solid reaction mixture is extracted with 100 ml hexane three times under nitrogen. The hexane is then stripped off under vacuum, and the resulting solid is sublimed under dynamic vacuum to yield pure cobalt (+2) compound.

Metallation of the novel 1-azaallyl ligands of this invention disclosure can be accomplished in many ways, and a wide range of metal reagents can be selected for reaction with 1-azaallyls to pursue alternative synthetic routes to 1-azaallyl metal complexes. For example, in the case of [-CuN(Et)=C(tBu)C($SiMe_3$)(H)-CuN(Et)=C(tBu)C($SiMe_3$)(H)-], the $Me_3SiCH_2C$(t-Bu)=N(Et) ligand can be effectively metallated by first forming a $Me_3SiCH$(X)C(t-Bu)=N(Et) type compound, where X is a halogen and reacting it with a metal, such as, but not limited to; magnesium, lithium, aluminum, sodium, potassium, cesium, or rubidium. Alternatively, the $Me_3SiCH$(X)C(t-Bu)=N(Et) type compound can be reacted with an organometallic species, such as an alkyl lithium, to undergo a metal/halogen to generate the $Me_3SiCH$(M)C(t-Bu)=N(Et) metallated species. Alternatively, the $Me_3SiCH_2C$(t-Bu)=N(Et) type compound can be deprotonated using an organometallic reagent, such as lithium diisopropylamide. Alternatively, the $Me_3SiCH_2C$(t-Bu)=N(Et) species can be metalated electrochemically, including this metallization step being directly to the finished product. If the metallated species does not constitute the desired finished product, then it can be reacted with a final metal reagent to create the desired final product through an effective exchange of metal centers. Suitable metal reagent sources from which to form the final complex include, but are not limited to; metal halides, acetates, fluoroacetates, triflate, alkoxides, amides, metal organometallics, hexafluorophosphates, copper tetrafluoroborate or other metal compounds. The final product may be purified by sublimation, distillation, recrystallization, selective reversible absorbtion, selective and reversible adduct formation with a suitable coordinating medium, or column chromatography using a chromatographic medium that is benign towards the organometallic copper compound product.

The unique 1-azaallyl compounds of the present invention and their metal ligand complexes offer significant advantages over the prior art metal film/layers prior art precursors. The 1-azaallyl compounds and metal ligand complexes are capable of releasing and depositing their entire metal content upon reaction, they have relatively high volatility and relatively low melting points to enhance delivery methods and options. By chemically tailoring the structure of these new ligands and their metal complexes, they are able to provide superior opportunities for stability, volatility and the deposition of metal films made under various protocols, such as; CVD and ALD. These physical and chemical property advantages are of significant importance to the semiconductor fabrication industry, as it attempts to more fully incorporate copper metal into integrated circuit designs, as well as other metals for other functionalities in semiconductor fabrication. Of course, these 1-azaallyl compounds and their corresponding metal ligand complexes have utility in non-semiconductor applications where metal depositions under more moderate conditions, than the prior art afforded, is desired.

The present invention has been set forth with regard to several preferred embodiments, however, the full scope of the invention should be ascertained from the claims which follow.

## Claims

1. A 1-azaallyl compound of the formula:

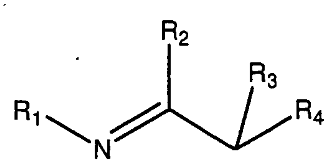

where $R_1$ is selected from the group consisting of H, $C_1$-$C_6$ alkyl, alkenyl, alkynyl, fluoroalkyl, fluoroalkyenyl, and fluoroalkynyl, $R_2$ is selected from the group consisting of H, $C_1$-$C_6$ alkyl, alkenyl, alkynyl, fluoroalkyl, fluoroalkyenyl, fluoroalkynyl, alkoxy, fluoroalkoxy $Si(R_5)_3$ where $R_5$ is alkyl, alkenyl, alkynyl, fluoroalkyl, fluoroalkyenyl, fluoroalkynyl, alkoxy, fluoroalkoxy; $R_3$ and $R_4$ are independently selected from the group consisting of H, $C_1$-$C_6$ alkyl, alkenyl, alkynyl, fluoroalkyl, fluoroalkyenyl, fluoroalkynyl, alkoxy, fluoroalkoxy, $Si(R_5)_3$ where $R_5$ is $C_1$-$C_6$ alkyl, alkenyl, alkynyl, fluoroalkyl, fluoroalkyenyl, and fluoroalkynyl, alkoxy, fluoroalkoxy.

**2.** The compound of Claim 1 wherein two $R_1$ groups from two identical or two different such 1-azaallyl compounds are connected through an aliphatic hydrocarbon bridge up to $C_6$ in length, optionally containing teriary amine or ether coordinating groups.

**3.** The compound of Claim 1 wherein $R_3$ and $R_4$ groups from one such 1-azaallyl compound can independently be connected to the $R_3$ and $R_4$ groups from another identical or different 1-azaallyl compound through an aliphatic hydrocarbon bridge up to $C_6$ in length.

**4.** A metal coordination complex of the compound of Claim 1 wherein the metal is selected from the group consisting of: lithium, copper, silver, iron, cobalt, zinc, magnesium, calcium, barium, strontium, sodium, potassium, gold and nickel.

**5.** A metal coordination complex of a 1-azaallyl compound of the formula:

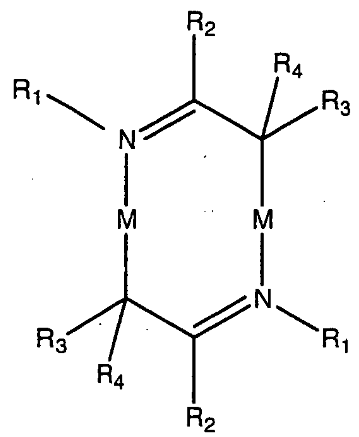

where $R_1$ is selected from the group consisting of H, $C_1$- $C_6$ alkyl, alkenyl, alkynyl, fluoroalkyl, fluoroalkyenyl, and fluoroalkynyl; $R_2$ is selected from the group consisting of H, $C_1$-$C_6$ alkyl, alkenyl, alkynyl, fluoroalkyl, fluoroalkyenyl, fluoroalkynyl, alkoxy, fluoroalkoxy, $Si(R_5)_3$ where $R_5$ is $C_1$-$C_6$ alkyl, alkenyl, alkynyl, fluoroalkyl, fluoroalkyenyl, fluoroalkynyl, alkoxy, fluoroalkoxy; $R_3$ and $R_4$ are independently selected from the group consisting of H, $C_1$-$C_6$ alkyl, alkenyl, alkynyl, fluoroalkyl, fluoroalkyenyl, fluoroalkynyl, alkoxy, fluoroalkoxy, $Si(R_5)_3$ where $R_5$ is $C_1$-$C_6$ alkyl, alkenyl, alkynyl, fluoroalkyl, fluoroalkyenyl, and fluoroalkynyl, alkoxy, or fluoroalkoxy; M is selected from the group consisting of: lithium, copper (I), sodium (I), potassium (I), gold (I) and silver (I).

**6.** A metal coordination complex of a 1-azaallyl compound of the formula:

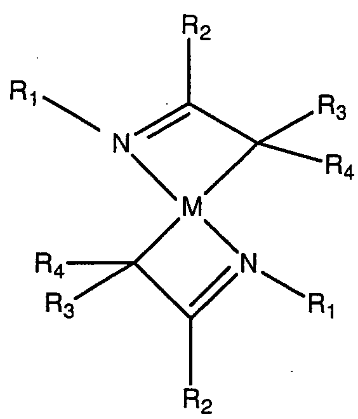

where $R_1$ is selected from the group consisting of H, $C_1$-$C_6$ alkyl, alkenyl, alkynyl, fluoroalkyl, fluoroalkyenyl, and fluoroalkynyl; $R_2$ is selected from the group consisting of H, $C_1$-$C_6$ alkyl, alkenyl, alkynyl, fluoroalkyl, fluoroalkyenyl,

fluoroalkynyl, alkoxy, fluoroalkoxy, $Si(R_5)_3$ where $R_5$ is $C_1$-$C_6$ alkyl, alkenyl, alkynyl, fluoroalkyl, fluoroalkyenyl, fluoroalkynyl, alkoxy, fluoroalkoxy; $R_3$ and $R_4$ are independently selected from the group consisting of H, $C_1$-$C_6$ alkyl, alkenyl, alkynyl, fluoroalkyl, fluoroalkyenyl, fluoroalkynyl, alkoxy, fluoroalkoxy, $Si(R_5)_3$ where $R_5$ is $C_1$-$C_6$ alkyl, alkenyl, alkynyl, fluoroalkyl, fluoroalkyenyl, and fluoroalkynyl, alkoxy, fluoroalkoxy; M is selected from the group consisting of: iron (II), cobalt (II), copper (II), zinc (II), magnesium (II), calcium (II), strontium (II), barium (II), palladium (II), platinum (II) and nickel (II).

**7.** A process for depositing a metal on a substrate using the 1-azaallyl metal compound of Claim 1 as a volatile precursor in a CVD process, where vapors of the precursor are contacted with a substrate surface in the presence of a gas, a reagent gas or gases under conditions of elevated temperature and/or a plasma, such that a chemical reaction occurs on the surface of the substrate to deposit a metal containing film.

**8.** The process of Claim 7 wherein the reagent gas is selected from the group consisting of hydrogen, silane and borane to deposit a metallic film on said substrate.

**9.** The process of Claim 7 wherein the reagent gas is selected from the group consisting of ammonia or hyrazine to deposit a metal nitride film on said substrate.

**10.** The process of Claim 7 wherein the reagent gas is an oxidant to deposit a metal oxide film on said substrate.

**11.** The process of Claim 7 wherein two or more metal precursors are used simultaneously to deposit a metal alloy or a mixed metal compound film on said substrate.

**12.** A process for depositing a metal or mixed metal on a substrate using metal coordination complexes of the 1-azaallyl compounds described in Claim 1 as volatile precursors in a ALD processes, where vapors of the precursor or precursors are alternately pulsed with a reagent gas optionally in the presence of a plasma in one or more pulse cycles to deposit one mono-layer or less of metal containing material per pulse cycle.

**13.** The process of Claim 12 wherein the reagent gas is selected from the group consisting of hydrogen, atomic hydrogen from a remotely located plasma, a silane, a borane, and alane to deposit a metallic film or metal alloy film on said substrate.

**14.** The process of Claim 12 wherein the reagent gas is selected from the group consisting of ammonia or hydrazine to grow a single metal nitride or a mixed metal nitride depending on the number of precursors being utilized to deposit a metal nitride film on said substrate.

**15.** The process of Claim 12 wherein the reagent gas is an oxidant to deposit a metal oxide film or mixed metal oxide, depending on the number of precursors being utilized ,on said substrate.

**16.** The process of Claim 12 wherein two or more metal precursors are used in sequential pulse cycles to deposit a metal alloy or a mixed metal compound film on said substrate.

**17.** The compound $Et(N)C(tBu)CH_2SiMe_3$, wherein Et = ethyl, tBu = tertiary butyl and Me = methyl.

**18.** A metal coordination complex of a 1-azaallyl compound of the formula:

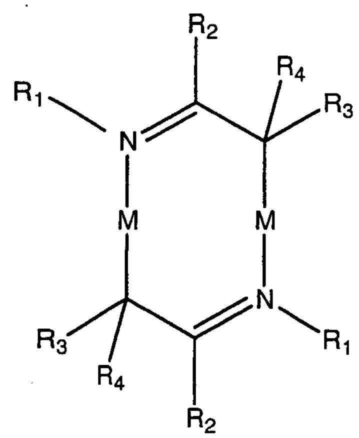

where $R_1$ is ethyl; $R_2$ is tertiary butyl, $R_3$ and $R_4$ are $Si(CH_3)_3$ and M = copper (I).

**19.** A metal coordination complex of a 1-azaallyl compound of the formula:

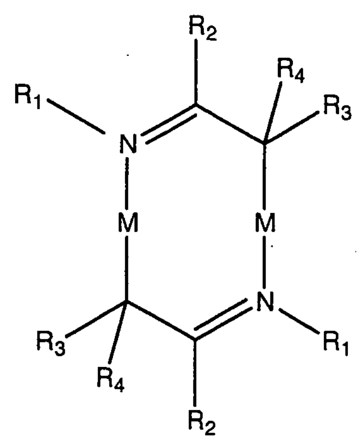

where $R_1$ is ethyl; $R_2$ is tertiary butyl, $R_3$ and $R_4$ are $Si(CH_3)_3$ and M = silver (I).

**20.** A metal coordination complex of a 1-azaallyl compound of the formula:

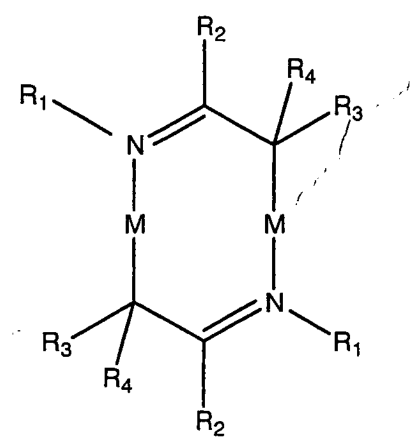

where $R_1$ is ethyl; $R_2$ is tertiary butyl, $R_3$ and $R_4$ are $Si(CH_3)_3$ and M = lithium (I).

**21.** The metal coordination complex of Claim 5, wherein two $R_1$ groups from two identical or two different 1-azaallyl compounds can be can be connected through an aliphatic hydrocarbon bridge up to $C_6$ in length, optionally, containing teriary amine or ether coordinating groups.

**22.** The metal coordination complex of Claim 5, wherein $R_3$ and $R_4$ groups from one 1-azaallyl compound can independently be connected to the $R_3$ and $R_4$ groups from another identical or different 1-azaallyl compound through an aliphatic hydrocarbon bridge up to $C_6$ in length.

**23.** The metal coordination complex of Claim 6, wherein two $R_1$ groups from two identical or two different 1-azaallyl compounds can be can be connected through an aliphatic hydrocarbon bridge up to $C_6$ in length, optionally, containing teriary amine or ether coordinating groups.

**24.** The metal coordination complex of Claim 6, wherein $R_3$ and $R_4$ groups from one 1-azaallyl compound can independently be connected to the $R_3$ and $R_4$ groups from another identical or different 1-azaallyl compound through an aliphatic hydrocarbon bridge up to $C_6$ in length.

**25.** A compound of the formula $[Me_3SiCHC(tBu)=N(Et)]_2$ $(M^{+2})$ wherein $M^{+2}$ is selected from the group consisting of; magnesium, strontium, barium, iron, nickel, palladium, platinium, and zinc.

**26.** A compound of the formula $[Me_3SiCHC(tBu)=N(Et)]_3$ $M^{+3}$ wherein $M^{+3}$ is selected from the group consisting of; yttrium, lanthanum, titanium, zirconium, hafnium, niobium, tanatlum, chromium, tungsten, ruthenium, osmium, rhodium, iridium, silver, gold, cobalt, ruthenium, rhodium, platinum, palladium, nickel, osmium, iridium, iron, sodium, potassium and lithium.

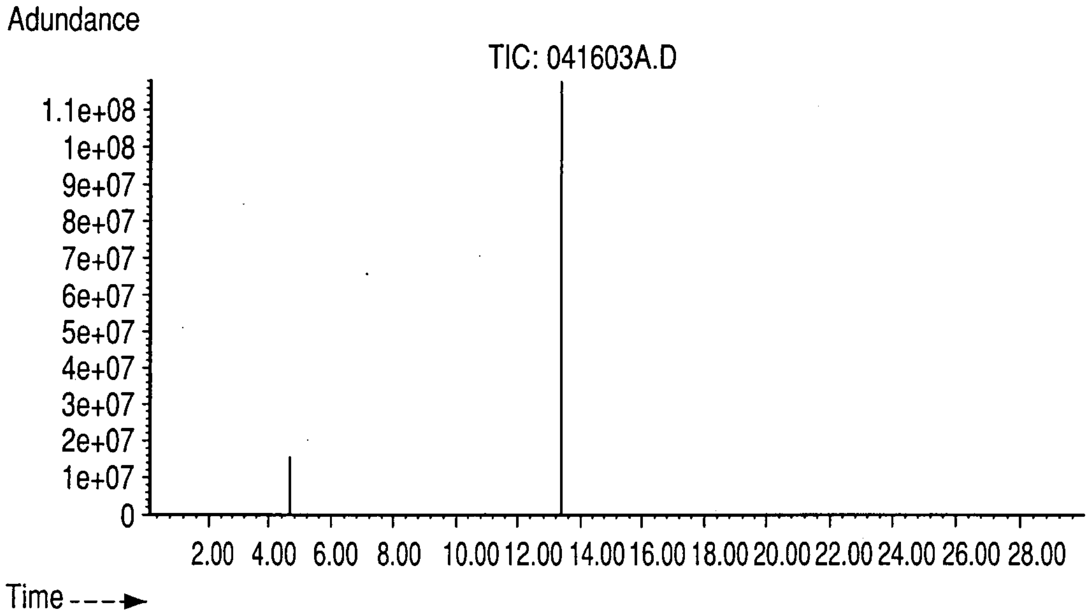


Figure 1

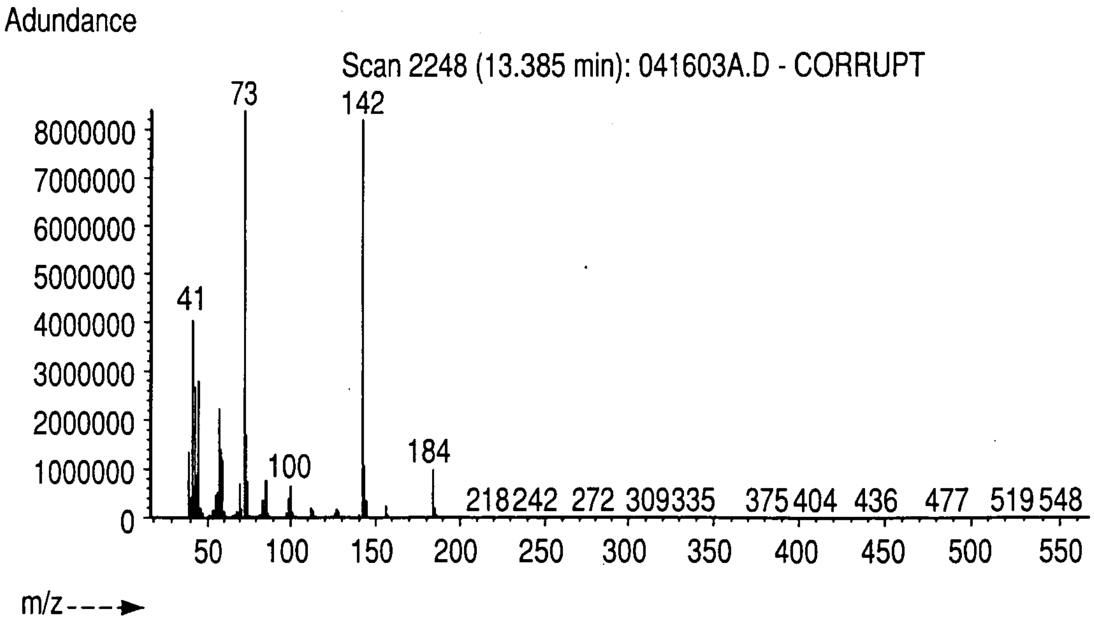


Figure 2

European Patent Office

**PARTIAL EUROPEAN SEARCH REPORT**
which under Rule 45 of the European Patent Convention shall be considered, for the purposes of subsequent proceedings, as the European search report

Application Number
EP 04 00 9212

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | TIETZE L F ET AL: "Efficient synthesis of branched propargyl- and allylsilanes" SYNTHESIS, GEORG THIEME VERLAG. STUTTGART, DE, no. 8, August 1995 (1995-08), pages 1003-1006, XP001182810 ISSN: 0039-7881 * compounds 1 and 2a to 2f * | 1 | H01L21/285 C23C16/18 C07F1/00 C07F3/00 C07F15/00 |
| X | PINSKER O A ET AL: "Highly stereoselective synthesis of a sex pheromone of the dry bean beetle callosobruchus analis" RUSSIAN CHEMICAL BULLETIN, PLENUM PUBLISHING CO, NEW YORK, NY, US, vol. 48, no. 7, July 1999 (1999-07), pages 1373-1375, XP009034223 ISSN: 1066-5285 * compounds 2 and 3 * | 1 | |
| | -/-- | | |

TECHNICAL FIELDS SEARCHED (Int.Cl.7)
H01L
C23C
C07F

## INCOMPLETE SEARCH

The Search Division considers that the present application, or one or more of its claims, does/do not comply with the EPC to such an extent that a meaningful search into the state of the art cannot be carried out, or can only be carried out partially, for these claims.

Claims searched completely :

Claims searched incompletely :

Claims not searched :

Reason for the limitation of the search:

see sheet C

| Place of search | Date of completion of the search | Examiner |
|---|---|---|
| Munich | 31 August 2004 | Elliott, A |

CATEGORY OF CITED DOCUMENTS
X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C07)

European Patent Office

**INCOMPLETE SEARCH SHEET C**

Application Number
EP 04 00 9212

Claim(s) searched completely:
7-20, 25,26

Claim(s) searched incompletely:
1-6, 21-24

Claim(s) not searched:
-

Reason for the limitation of the search:

Present claims 1-6 and 21-24 relate to an extremely large number of possible compounds. Support within the meaning of Article 84 EPC and/or disclosure within the meaning of Article 83 EPC is to be found, however, for only a very small proportion of the compounds claimed. In the present case, the claims so lack support, and the application so lacks disclosure, that a meaningful search over the whole of the claimed scope is impossible. Consequently, the search has been carried out for those parts of the claims which appear to be supported and disclosed, namely those parts relating to the compounds which contain silicon substitution at the carbon atoms of the 1-azaallyl compound as defined in claim 1.

European Patent Office

# PARTIAL EUROPEAN SEARCH REPORT

Application Number
EP 04 00 9212

| DOCUMENTS CONSIDERED TO BE RELEVANT | | | CLASSIFICATION OF THE APPLICATION (Int.Cl.7) |
|---|---|---|---|
| Category | Citation of document with indication, where appropriate, of relevant passages | Relevant to claim | |
| X | POPOWSKI E: "Darstellung und spektroskopische Untersuchungen Triorganoelementsubstituierter N-Alkyliden-alkylamine (El = C, Si, Sn)" ZEITSCHRIFT FUER CHEMIE, DEUTSCHER VERLAG FUER GRUNDSTOFFINDUSTRIE,, DE, vol. 17, no. 9, 1977, pages 341-342, XP009034233 ISSN: 0044-2402 * page 341, column 1 and tables 1 & 2 * ----- | 1 | |
| X | SARMA A S: "On the regiochemistry of the reaction of lithioketimines with chlorotrimethylsilane" INDIAN JOURNAL OF CHEMISTRY, SECTION B: ORGANIC, INCL. MEDICINAL, PUBLICATIONS & INFORMATIONS DIRECTORATE, NEW DELHI, IN, vol. 18B, July 1979 (1979-07), pages 84-85, XP009034220 ISSN: 0019-5103 * compounds 1c & 3c * ----- | 1 | TECHNICAL FIELDS SEARCHED (Int.Cl.7) |
| X | BELLASSOUED M ET AL: "A Simple and highly stereoselective route to E-alpha,beta-unsaturated aldehydes" JOURNAL OF ORGANIC CHEMISTRY, AMERICAN CHEMICAL SOCIETY. EASTON, US, vol. 58, no. 9, 23 April 1993 (1993-04-23), pages 2517-2522, XP000362130 ISSN: 0022-3263 * compounds 2, 3, 4 & 11 * ----- | 1 | |
| | -/-- | | |

EPO FORM 1503 03.82 (P04C10)

European Patent Office

# PARTIAL EUROPEAN SEARCH REPORT

Application Number
EP 04 00 9212

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | ALVAREZ R ET AL: "Stereoselective Synthesis Of Polyenic Alarm Pheromones Of Cephalaspidean Molluscs" TETRAHEDRON, ELSEVIER SCIENCE PUBLISHERS, AMSTERDAM, NL, vol. 54, no. 24, 11 June 1998 (1998-06-11), pages 6793-6810, XP004122516 ISSN: 0040-4020 * scheme 3, compound 34 * ----- | 1 | |
| X | MEAD D ET AL: "9-Cis and 11-cis isomers of 18,18,18-, 19,19,19- and 20,20,20-trifluororetinal" TETRAHEDRON LETTERS, ELSEVIER SCIENCE PUBLISHERS, AMSTERDAM, NL, vol. 28, no. 3, 1987, pages 259-262, XP000578125 ISSN: 0040-4039 * reagent i * ----- | 1 | TECHNICAL FIELDS SEARCHED (Int.Cl.7) |
| X | WANG J ET AL: "Oligomerisation and hydroamination of terminal alkynes promoted by the cationic organoactinide compound [(Et2N)3U][BPh4]" CHEMISTRY, A EUROPEAN JOURNAL, vol. 8, no. 23, 2002, pages 5384-5396, XP002292671 ISSN: 0947-6539 * compounds 5 to 9 & 13; table 2 * ----- | 1 | |
| X | FOURTINON M ET AL: "Synthèse ambidoselective d'enamines et d'imines siliciées" JOURNAL OF ORGANOMETALLIC CHEMISTRY, vol. 193, 8 July 1980 (1980-07-08), pages 165-174, XP002292672 * table 3 * ----- | 1 | |

-/--

EPO FORM 1503 03.82 (P04C10)

European Patent Office

# PARTIAL EUROPEAN SEARCH REPORT

Application Number
EP 04 00 9212

| DOCUMENTS CONSIDERED TO BE RELEVANT | | | CLASSIFICATION OF THE APPLICATION (Int.Cl.7) |
|---|---|---|---|
| Category | Citation of document with indication, where appropriate, of relevant passages | Relevant to claim | |
| X | SCHLESSINGER R H ET AL: "The vinylogation of aldehydes: an improved method for the preparation of alpha formylethylidenetriphenylphosphorane, and an improved alpha silyl imine reagent of propionaldehyde" TETRAHEDRON LETTERS, vol. 26, no. 20, 1985, pages 2391-2394, XP002292673 * compounds 2 & 5 and the precursor of 5 * ----- | 1 | |
| X | CROTEAU A A ET AL: "A convenient route to alpha,beta-unsaturated methyl ketones; application of retinal analogue synthesis" TETRAHEDRON LETTERS, vol. 24, no. 24, 1983, pages 2481-2484, XP002292674 * compounds 1a & 1b * ----- | 1 | TECHNICAL FIELDS SEARCHED (Int.Cl.7) |
| D,X | CARO C F ET AL: "Review of metal 1-azaallyl complexes" COORDINATION CHEMISTRY REVIEWS, vol. 219-221, 2001, pages 605-663, XP002292675 ISSN: 0010-8545 * the whole document, in particular, figure 1 * * the whole document * ----- | 1 | |
| A | HITCHCOCK P B ET AL: "Synthesis and molecular structures of copper(I) 1-azaallyls" JOURNAL OF THE CHEMICAL SOCIETY, DALTON TRANSACTIONS, no. 10, 1998, pages 1619-1623, XP002292676 ISSN: 0300-9246 * compound 2 * ----- | 5 | |
| | -/-- | | |

EPO FORM 1503 03.82 (P04C10)

European Patent Office

# PARTIAL EUROPEAN SEARCH REPORT

Application Number
EP 04 00 9212

| Category | Citation of document with indication, where appropriate, of relevant passages | Relevant to claim | CLASSIFICATION OF THE APPLICATION (Int.Cl.7) |
|---|---|---|---|
| A | HITCHCOCK P B ET AL: "Spectroscopic and electronic properties of 1-azaallylmetal (I) (M = Cu or Au) complexes; molecular structure of [{Au[mu-N(R)C(Ph)CR2]}2] (R = SiMe3)" JOURNAL OF THE CHEMICAL SOCIETY, DALTON TRANSACTIONS, no. 9, 1999, pages 1455-1459, XP002292677 ISSN: 0300-9246 * compound 1 * ----- | 5 | |
| A | CUI C ET AL: "Synthesis and characterisation of 1-aza-allyl complexes of aluminium, gallium and bismuth" POLYHEDRON, vol. 19, no. 4, 28 February 2000 (2000-02-28), pages 471-474, XP002292678 ISSN: 0277-5387 * compound 3 * ----- | 6 | TECHNICAL FIELDS SEARCHED (Int.Cl.7) |
| A | CARO C F ET AL: "Monomeric magnesium 1-azaallyl and beta-ketiminato complexes derived from the bis(trimethylsilyl)methyl ligand: the X-ray structure of the four-coordinate planar magnesium complex [Mg{N(R)C(t-Bu)C(H)R}2] and of [Mg({N(R)C(Ph)}2CH)2]" CHEMICAL COMMUNICATIONS, 1999, pages 1433-1434, XP002292682 * compound 1 * ----- | 6 | |
| A | HITCHCOCK P B ET AL: "Variation in bonding modes in homoleptic tin(II) 1-azaallyls" CHEMICAL COMMUNICATIONS, 1997, pages 1189-1190, XP002292683 * compound 2 * ----- -/-- | 6 | |

EPO FORM 1503 03.82 (P04C10)

European Patent Office

# PARTIAL EUROPEAN SEARCH REPORT

Application Number
EP 04 00 9212

| DOCUMENTS CONSIDERED TO BE RELEVANT | | | CLASSIFICATION OF THE APPLICATION (Int.Cl.7) |
|---|---|---|---|
| Category | Citation of document with indication, where appropriate, of relevant passages | Relevant to claim | |
| D,A | US 5 144 049 A (NORMAN JOHN A T ET AL) 1 September 1992 (1992-09-01)<br>* the whole document *<br>----- | 1-26 | |
| | | | TECHNICAL FIELDS SEARCHED (Int.Cl.7) |

EPO FORM 1503 03.82 (P04C10)

## ANNEX TO THE EUROPEAN SEARCH REPORT ON EUROPEAN PATENT APPLICATION NO. EP 04 00 9212

This annex lists the patent family members relating to the patent documents cited in the above-mentioned European search report.
The members are as contained in the European Patent Office EDP file on
The European Patent Office is in no way liable for these particulars which are merely given for the purpose of information.

31-08-2004

| Patent document cited in search report | Publication date | Patent family member(s) | Publication date |
|---|---|---|---|
| US 5144049 A | 01-09-1992 | US 5085731 A | 04-02-1992 |
| | | DE 69218478 D1 | 30-04-1997 |
| | | DE 69218478 T2 | 03-07-1997 |
| | | EP 0498269 A2 | 12-08-1992 |
| | | JP 5059551 A | 09-03-1993 |
| | | JP 6049943 B | 29-06-1994 |
| | | KR 9411709 B1 | 23-12-1994 |
| | | US 5187300 A | 16-02-1993 |

EPO FORM P0459

For more details about this annex : see Official Journal of the European Patent Office, No. 12/82